# EUROPÄISCHE PATENTANMELDUNG

(11) **EP 1 109 213 A2**
(43) Veröffentlichungstag der Anmeldung: **20.06.2001**
(21) Anmeldenummer: 00125799.7
(22) Anmeldetag: 24.11.2000
(51) Int. Cl.: H01L 21/60

(54) **Verfahren zur Herstellung eines Halbleiterbausteins**

(30) Priorität: 14.12.1999 DE 19960249
(71) Anmelder: Infineon Technologies AG, 81669 München (DE)
(72) Erfinder: Neu, Achim, 93047 Regensburg (DE); Strutz, Volker, 93105 Tegernheim (DE); Uhlmann, Rügiger, Dr., 01109 Dresden (DE); Wege, Stephan, 01474 Weissig (DE)
(74) Vertreter: Fischer, Volker, Dipl.-Ing.

(57) **Zusammenfassung**

Es wird ein Verfahren zur Herstellung eines Halbleiterbausteins (1) vorgeschlagen, der einen Halbleiterchip (2) mit Verdrahtungsanschlüssen (3) und Leiterbahnen (4) zum elektrischen Anschluß des Halbleiterchips (2) aufweist sowie eine Komponente (5) einer Gehäuseanordnung, die organisches, siliziumhaltiges Material enthält. Der Halbleiterchip (2) wird dazu auf die Komponente (5) der Gehäuseanordnung aufgebracht und mit ihr dauerhaft verbunden. Die Leiterbahnen (4) und/oder die Verdrahtungsanschlüsse (3) werden im Anschluß einem Reinigungsprozeß unterzogen, in dem auf einer Oberfläche haftendes siliziumhaltiges Material beseitigt wird. Die Leiterbahnen (4) werden im Anschluß mit den Verdrahtungsanschlüssen (3) elektrisch leitend verbunden. Durch den vorgesehenen Reinigungsprozeß wird die Kontaktqualität dieser elektrischen Verbindungen spürbar verbessert.

## Beschreibung

Die vorliegende Erfindung betrifft ein Verfahren zur Herstellung eines Halbleiterbausteins, bei dem ein Halbleiterchip mit Verdrahtungsanschlüssen auf eine Komponente einer Gehäuseanordnung aufgebracht wird, die organisches, siliziumhaltiges Material enthält, und bei dem anschließend die Leiterbahnen mit den Verdrahtungsanschlüssen verbunden werden.

Integrierte Halbleiterbausteine werden in unterschiedlichen Anwendungen eingesetzt. Ein Halbleiterchip mit Verdrahtungsanschlüssen (sogenannte Bond Pads) ist dabei im allgemeinen in ein Gehäuse verpackt und auf einer Leiterplatte bzw. Platine aufgesetzt. Beispielsweise ist ein Halbleiterbaustein in einer Gehäuseanordnung gemäß einer sogenannten FBGA-Gehäuseanordnung (FBGA: Fine Pitch Ball Grid Array) angeordnet, die insbesondere auf der sogenannten Beam-Lead-Bonding-Technik basiert. Diese Art von Gehäuseanordnung ist vor allem vorteilhaft bei Halbleiterspeicherbausteinen in Rambus-Technik mit vergleichsweise hohen Taktraten einsetzbar, da infolge des spezifischen Anordnungsdesigns insbesondere Leitungsinduktivitäten relativ gering sind.

Eine FBGA-Gehäuseanordnung, auch als FBGA-Package bezeichnet, umfaßt üblicherweise einen Halbleiterchip mit Anschlüssen zur elektrischen Verbindung mit den Anschlüssen der Platine sowie eine flexible Leiterplatte (auch als Interposer bezeichnet) mit einer Trägerschicht und darauf aufgebrachten Leiterbahnen. Auf dem Interposer wiederum sind üblicherweise mehrere Abstandsstücke (auch als Nubbins bezeichnet) aufgebracht.

Bei der Montage des Halbleiterchips wird dieser zunächst mit oder ohne einer zusätzlichen Kleberschicht auf diesen Abstandsstücken befestigt (sogenanntes Die Bonden), wodurch zwischen Halbleiterchip und Interposer ein schmaler Zwischenraum entsteht. Die Abstandsstücke und der Kleber bestehen entsprechend den üblichen Konstruktionsvorgaben aus organischen siliziumhaltigen Materialien. In einem anschließenden Fertigungsschritt (sogenanntes Lead Bonden) werden Teile der Leiterbahnen (sogenannte Leads) von dem Interposer auf die Verdrahtungsanschlüsse des Halbleiterchips gebogen und dort mit Hilfe von Wärme, Druck und Ultraschall aufgeschweißt. Die Anforderungen an die Qualität der geschweißten Kontakte sind relativ hoch, damit die Funktionsfähigkeit des Halbleiterbausteins auch unter hohen elektrischen Anforderungen, beispielsweise bei hohen Taktraten, gewährleistet ist.

Zur Befestigung des Halbleiterchips auf den Abstandsstücken wird der Halbleiterbaustein üblicherweise einem Prozeß mit entsprechend erhöhter Prozeßtemperatur unterzogen, bei dem siliziumhaltiges Material der Kleberschicht und der Abstandsstücke freigesetzt wird. Dieses haftet dann im allgemeinen auf den Oberflächen der Leiterbahnen und/oder Verdrahtungsanschlüsse des Halbleiterchips als Verunreinigungsschicht. Dies verschlechtert die Kontaktqualität beim späteren Anschluß der Leiterbahnen an die Verdrahtungsanschlüsse des Halbleiterchips.

Die Aufgabe der vorliegenden Erfindung ist es, ein Verfahren zur Herstellung eines Halbleiterbausteins anzugeben, bei dem ein Halbleiterchip auf eine siliziumhaltige Komponente einer Gehäuseanordnung aufgebracht wird, und welches eine relativ hohe Kontaktqualität beim späteren Anschluß der Leiterbahnen an die Verdrahtungsanschlüsse des Halbleiterchips gewährleistet.

Die Aufgabe wird gelöst durch ein Verfahren zur Herstellung eines Halbleiterbausteins nach den Merkmalen des Patentanspruchs 1. Vorteilhafte Aus- und Weiterbildungen sind Gegenstand abhängiger Ansprüche.

Erfindungsgemäß wird der Halbleiterchip auf eine Komponente einer Gehäuseanordnung, die organisches siliziumhaltiges Material enthält, aufgebracht und mit der Komponente der Gehäuseanordnung dauerhaft verbunden. Leiterbahnen zum elektrischen Anschluß des Halbleiterchips und/oder Verdrahtungsanschlüsse des Halbleiterchips werden im Anschluß einem Reinigungsprozeß unterzogen, in dem auf einer Oberfläche haftendes siliziumhaltiges Material beseitigt wird. Im Anschluß werden die Leiterbahnen mit den Verdrahtungsanschlüssen des Halbleiterchips elektrisch leitend verbunden. Der Reinigungsprozeß sorgt dafür, daß eine vorhandene Verunreinigungsschicht aus siliziumhaltigem Material entfernt wird. Eine derartige Verunreinigungsschicht kann sich auf den Leiterbahnen und/oder Verdrahtungsanschlüssen des Halbleiterchips befinden.

Es werden dabei Verunreinigungen beseitigt, die vor dem Aufbringen des Halbleiterchips vorhanden sind, und Verunreinigungen, die durch das Aufbringen des Halbleiterchips hinzu kommen. Die beschriebene Reihenfolge der Verfahrensschritte sorgt dafür, daß beim Anschluß der Leiterbahnen durch saubere Oberflächen eine gute Kontaktqualität ermöglicht wird.

Ist bei der Herstellung eines Halbleiterbausteins anderweitig beispielsweise bereits ein Verfahrensschritt zur Reinigung von Vorrichtungen von z.B. Kohlenstoffverbindungen vorgesehen, kann dieser in erfindungsgemäßer Weise abgeändert werden. Mit dem beschriebenen Reinigungsprozeß können zusätzlich die Trägerschicht und die darauf befindlichen Leiterbahnen (Interposer) sowie die darauf befindlichen Abstandsstücke vor dem Aufbringen den Halbleiterchips gereinigt werden.

Eine vorteilhafte Weiterbildung der Erfindung sieht vor, daß die Leiterbahnen zusätzlich dem beschriebenen Reinigungsprozeß unterzogen werden, bevor der Halbleiterchip auf die Komponente der Gehäuseanordnung aufgebracht wird. Dieser Reinigungsschritt ist vorgesehen, um vorhandene Verunreinigungen von siliziumhaltigem Material, die bereits vor dem Aufbringen des Halbleiterchips vorhanden sind, vor dem Aufbringen zu entfernen. Dies kann die Kontaktqualität beim späteren Anschluß der Leiterbahnen zusätzlich verbessern.

In einer vorteilhaften Ausgestaltung der Erfindung weist der Reinigungsprozeß ein Plasmaätzverfahren auf. Der zur Beseitigung einer Verunreinigungsschicht erforderliche Ätzabtrag erfolgt durch Trockenätzen mittels Atomen bzw. Molekülen aus einem Gas und/oder durch Beschuß der zu ätzenden Oberfläche mit Ionen, Photonen oder Elektronen. Der Ätzprozeß kann beispielsweise physikalischer oder chemischer Art sein.

Zum ganzflächigen Abätzen von Schichten kann beispielsweise ein chemisches Plasmaätzverfahren verwendet werden. Dort findet eine chemische Ätzreaktion zwischen angeregten Teilchen eines Reaktionsgases und Atomen der zu ätzenden Oberfläche statt. Es wird also durch das Reaktionsgas auf einer Oberfläche haftendes siliziumhaltiges Material chemisch umgewandelt und von der Oberfläche abgelöst. Voraussetzung für einen derartigen Reinigungsvorgang ist dabei die Bildung eines gasförmigen flüchtigen Reaktionsproduktes, das im gasförmigen Zustand abgeführt werden kann.

Dabei ist es günstig, daß das Reaktionsgas einen Bestandteil an Fluor aufweist. Beispielsweise bilden angeregte Fluoratome aus dem Plasma mit den Atomen der mit siliziumhaltigem Material verunreinigten Oberfläche das flüchtige Reaktionsprodukt SiF4.

Als Reaktionsgas kann beispielsweise CF4, SF6 oder NF3 verwendet werden. Bei dem Reinigungsprozeß mit dem beschriebenen Plasmaätzverfahren kann es dabei zu unerwünschten Nebenprodukten kommen, die sich auf den zu reinigenden Oberflächen niederschlagen können. Beispielsweise ist bei der Verwendung von CF4 eine verstärkte Neigung zur Abscheidung von Kohlenstoffverbindungen (beispielsweise Polymerabscheidungen) zu beobachten. Aber auch bei der Verwendung von SF6 bzw. NF3 werden Reaktionsprodukte gebildet, die durch die Anwendung des Reinigungsprozesses entstehen. Diese können beispielsweise daraus resultieren, daß bei der Reinigung mittels des Reaktionsgases auch umgebendes Material betroffen ist, das nicht von Verunreinigungen gereinigt werden soll.

Daher ist es günstig, daß nach dem Reinigungsprozeß ein weiterer Reinigungsprozeß durchgeführt wird, der ein auf einer Oberfläche haftendes Reaktionsprodukt entfernt, das durch die Anwendung des Reinigungsprozesses zur Beseitigung von siliziumhaltigem Material entsteht. Dieser weitere Reinigungsprozeß trägt dazu bei, daß unerwünschte Nebenprodukte der vorhergehenden Plasma-Reinigung nicht zur Verschlechterung der Kontaktqualität beitragen. Dieser weitere Reinigungsprozeß kann ebenso wie der vorhergehende Reinigungsprozeß zur Entfernung von siliziumhaltigem Material mehrfach durchgeführt werden, um das Reinigungsergebnis weiterhin zu verbessern.

Da die Wirkungsweise des weiteren Reinigungsprozesses ähnlich der Wirkungsweise des vorhergehenden Reinigungsprozesses zur Entfernung von siliziumhaltigem Material ist, weist der weitere Reinigungsprozeß vorteilhafterweise ein Plasmaätzverfahren auf.

Die Erfindung wird nachfolgend anhand der in der Zeichnung dargestellten Figuren näher erläutert. Es zeigen
- Figur 1: einen Querschnitt eines Halbleiterbausteins in FBGA-Gehäuseanordnung,
- Figur 2: eine schematische Darstellung der Konfiguration einer Vorrichtung für ein Plasma-Ätzverfahren.

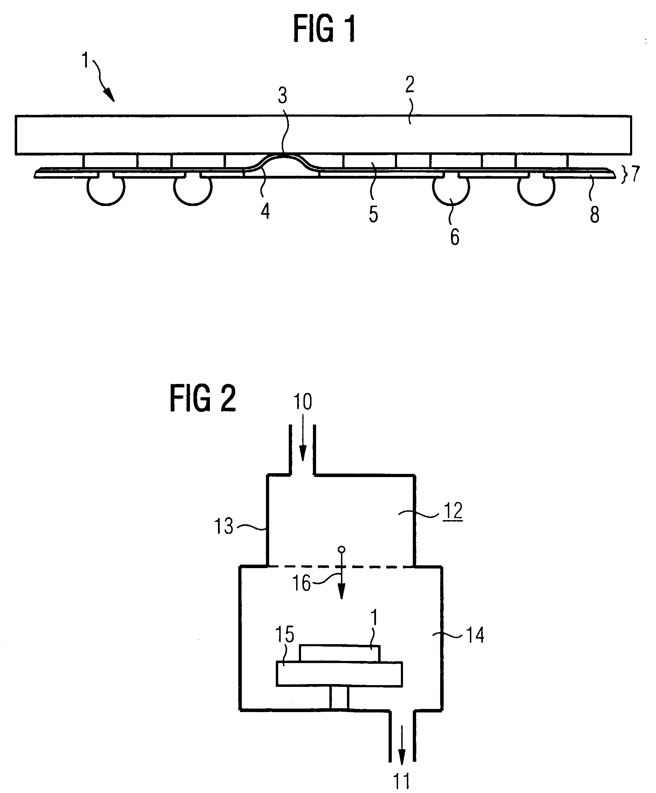

Figur 1 zeigt einen Querschnitt eines Halbleiterbausteins 1 in sogenannter FBGA-Gehäuseanordnung. Zur Herstellung dieser Gehäuseanordnung wird eine flexible Leiterplatte 7 (Interposer), bestehend aus einer Trägerschicht 8 und Leiterbahnen 4 verwendet, auf die mehrere Abstandsstücke 5 aufgebracht sind. Beim sogenannten Die-Bonden wird der Halbleiterchip 2 mit den Verdrahtungsanschlüssen 3 auf diesen Abstandsstücken 5 mit oder ohne einer zusätzlichen Kleberschicht befestigt. Dadurch entsteht zwischen dem Halbleiterchip 2 und dem Interposer 7 ein schmaler Zwischenraum. Die Abstandsstücke 5 und die eventuell verwendete Kleberschicht bestehen entsprechend den Konstruktionsvorgaben aus organischen silikongummihaltigen Materialien (beispielsweise Polymeren). Der Interposer 7 ist über Lötkugeln 6 beispielsweise mit einer Platine verbunden.

Im Fertigungsschritt des sogenannten Lead-Bondens werden Teile der Leiterbahnen 4 (Leads) vom Interposer 7 auf die sogenannten Bond Pads 3 des Halbleiterchips 2 gebogen und dort mit Hilfe von Wärme, Druck und Ultraschall aufgeschweißt. Im Interesse einer guten Kontaktqualität sollten die einander berührenden Oberflächen der Leiterbahnen 4 bzw. der Bond Pads 3 insbesondere frei von siliziumhaltigen Verunreinigungen sein. Diese können im Verfahren zur Herstellung des Halbleiterbausteins 1 entstehen, wenn der Halbleiterchip 2 auf die Abstandsstücke 5 aufgebracht und mit diesen dauerhaft verbunden wird. Bevor die Leiterbahnen 4 mit den Bond Pads 3 des Halbleiterchips 2 elektrisch leitend verbunden werden, werden die Leiterbahnen 4 und/oder die Bond Pads 3 einem Reinigungsprozeß unterzogen, in dem vorhandene siliziumhaltige Verunreinigungen beseitigt werden.

In Figur 2 ist eine schematische Konfiguration einer Vorrichtung für ein Plasmaätzverfahren dargestellt. Zum Ätzen wird der vorher nahezu evakuierten Reaktionskammer 14 ein geeignetes Reaktionsgas 10 zugeführt. Als Reaktionsgas 10 dient beispielsweise Sauerstoff mit 5 - 20 % Zusatz des Reaktionsgases CF4. Aus dem Reaktionsgas 10 wird in der Kammer 13 ein Plasma 12 erzeugt. Aus dem Plasma 12 diffundieren angeregte Atome oder Moleküle zu dem Halbleiterbaustein 1 (Teilchenstrahl 16), der auf einem Träger 15 aufgebracht ist, und reagieren chemisch mit den Atomen der verunreinigten Oberflächen. Voraussetzung für das Ätzen ist die Bildung von flüchtigen Reaktionsprodukten, die von der Pumpe 11 abgesaugt werden können.

In einem weiteren Reinigungsprozeß werden auf den Oberflächen haftende Reaktionsprodukte entfernt, die beispielsweise durch die Anwendung des Reaktionsgases CF4 entstehen. Das dafür erneut angewandte Plasma-Reinigungsverfahren verwendet beispielsweise ein Reaktionsgas 10 bestehend aus reinem Sauerstoff. Dieser reagiert mit den auf den Oberflächen haftenden Kohlenstoffverbindungen zu Kohlendioxid bzw. Kohlenmonoxid (CO₂, CO), das durch die Pumpe 11 abgepumpt wird.

## Patentansprüche

1. Verfahren zur Herstellung eines Halbleiterbausteins (1), der einen Halbleiterchip (2) mit Verdrahtungsanschlüssen (3) und Leiterbahnen (4) zum elektrischen Anschluß des Halbleiterchips (2) aufweist sowie wenigstens eine Komponente (5) einer Gehäuseanordnung, die organisches, siliziumhaltiges Material enthält, umfassend die Schritte:
- der Halbleiterchip (2) wird zuerst auf die Komponente (5) der Gehäuseanordnung aufgebracht und mit der Komponente (5) der Gehäuseanordnung dauerhaft verbunden,
- die Leiterbahnen (4) und/oder die Verdrahtungsanschlüsse (3) werden im Anschluß daran einem Reinigungsprozeß unterzogen, in dem auf einer Oberfläche haftendes siliziumhaltiges Material entfernt wird,
- die Leiterbahnen (4) werden im Anschluß mit den Verdrahtungsanschlüssen (3) elektrisch leitend verbunden.

2. Verfahren nach Anspruch 1,
**dadurch gekennzeichnet**, **daß**
der Reinigungsprozeß ein Plasmaätzverfahren aufweist.

3. Verfahren nach Anspruch 2,
**dadurch gekennzeichnet**, **daß**
im Plasmaätzverfahren ein Reaktionsgas (10) verwendet wird, das auf einer Oberfläche haftendes siliziumhaltiges Material chemisch umwandelt und von der Oberfläche ablöst.

4. Verfahren nach Anspruch 3,
**dadurch gekennzeichnet**, **daß**
das Reaktionsgas (10) einen Bestandteil an Fluor aufweist.

5. Verfahren nach Anspruch 4,
**dadurch gekennzeichnet**, **daß**
das als Reaktionsgas (10) CF4, SF6 oder NF3 verwendet wird.

6. Verfahren nach einem der vorhergehenden Ansprüche,
**dadurch gekennzeichnet**, **daß**
nach dem Reinigungsprozeß ein weiterer Reinigungsprozeß durchgeführt wird, der ein auf einer Oberfläche haftendes Reaktionsprodukt entfernt, das durch die Anwendung des Reinigungsprozesses entsteht.

7. Verfahren nach Anspruch 6,
**dadurch gekennzeichnet**, **daß**
der weitere Reinigungsprozeß ein Plasmaätzverfahren aufweist.

8. Verfahren nach einem der vorhergehenden Ansprüche,
**dadurch gekennzeichnet**, **daß**
die Leiterbahnen zusätzlich dem Reinigungsprozeß unterzogen werden, bevor der Halbleiterchip auf die Komponente der Gehäuseanordnung aufgebracht wird.

9. Verfahren nach einem der vorhergehenden Ansprüche,
**dadurch gekennzeichnet**, **daß**
die Komponente (5) der Gehäuseanordnung in einer FBGA-Gehäuseanordnung enthalten ist.

10. Verfahren nach Anspruch 9,
**dadurch gekennzeichnet**, **daß**
die Komponente (5) der Gehäuseanordnung ein Abstandsstück einer FBGA-Gehäuseanordnung aufweist.
